# EUROPÄISCHE PATENTANMELDUNG

(11) **EP 1 143 508 A2**
(43) Veröffentlichungstag der Anmeldung: **10.10.2001**
(21) Anmeldenummer: 01106481.3
(22) Anmeldetag: 23.03.2001
(51) Int. Cl.: H01L 23/24, H01L 21/56

(54) **Vorrichtung zum Verpacken von elektronischen Bauteilen**

(30) Priorität: 23.03.2000 DE 10014380
(71) Anmelder: Infineon Technologies AG, 81669 München (DE)
(72) Erfinder: Hauser, Christian, 93049 Regensburg (DE); Pohl, Jens, 93170 Bernhardswald (DE); Winderl, Johann, 92442 Wackersdorf (DE)
(74) Vertreter: Hanke, Hilmar, Dipl.-Ing.

(57) **Zusammenfassung**

Die Erfindung betrifft eine Vorrichtung und ein Verfahren zum Verpacken von elektronischen Bauteilen (11) mit Halbleiterchips (5) mittels eines Montagerahmens (1), der zusätzlich ein Kunststoffgitter (6), das auf einem Kunststoffzwischenträger (2) angeordnet ist, welches jedes Halbleiterchip (5) rahmenartig umgibt, und welches zum Verpacken der Vielzahl von Halbleiterchips (5) mit einer Kunststoffgußmasse (7) zwischen Halbleiterchips (5) und Kunststoffgitter (6) versehen ist.

## Beschreibung

Die Erfindung betrifft eine Vorrichtung zum Verpacken von elektronischen Bauteilen und ein Verfahren zum Verpacken von elektronischen Bauteilen.

Eine Verpackungsart von elektronischen Bauteilen wird BGA-Gehäuse (ball-grid-array-Gehäuse) genannt. Die Vorrichtung zum Verpacken von elektronischen Bauteilen in BGA-Gehäusen weist einen Montagerahmen auf, der einen Kunststoffzwischenträger umrahmt und hält. Der Kunststoffzwischenträger weist eine Vielzahl von Kontakthöckern mit angeschlossenen Leiterbahnen auf, die zu einer Vielzahl von Halbleiterpositionen innerhalb des zugehörigen Montagerahmens führen. In diesen Halbleiterchippositionen sind Halbleiterchips angebracht, deren Kontaktflächen mit den Leiterbahnen des Kunststoffzwischenträgers verbunden sind. Gleichzeitig sorgen Abstandshalter oder Abstandsschichten aus Kunststoff dafür, daß die Halbleiterchips auf dem Kunststoffzwischenträger in den Halbleiterchippositionen gehalten werden. Dazu können die Abstandshalter oder Abstandsschichten, die aus einer Silikonmasse bestehen, mit Klebstoff beschichtet sein.

Zum Verpacken der Vielzahl von Halbleiterchips mit einer Kunststoffgußmasse wird diese zum Auffüllen der Zwischenräume zwischen den Halbleiterchips untereinander und der Hohlräume zwischen den Halbleiterchips und dem Kunststoffzwischenträger sowie dem Montagerahmen vergossen. Danach wird der Kunststoffzwischenträger im Bereich der Kunststoffgußmasse zwischen den Halbleiterchips zersägt und damit das Verpacken der elektronischen Bauteile beendet.

Beim Trennen wird das Sägeblatt durch die im wesentlichen aus Siliconmasse bestehende Kunststoffgußmasse geführt. Bei diesem Trennverfahren entstehen klebrige Ablagerungen der Sägerückstände, wie Siliconkugeln, so daß diese Ablagerungen in einem weiteren Säuberungsprozeß mechanisch entfernt werden. Ein derartiger Säuberungsprozeß ist kostenintensiv und aufwendig. Darüber hinaus bleiben ohne diesen mechanischen Säuberungsprozeß die Außenmaße und die Außenform der Gehäuse undefiniert. Zudem können bei nachfolgenden Fertigungsschritten die Sägerückstände abfallen und nachfolgende Einrichtungen, wie z.B. Testsockel, verschmutzen. Darüber hinaus hat sich gezeigt, daß ein Gehäuse, dessen Kontakthöckeranordnung auf dem Kunststoffzwischenträger in der Flächenausdehnung wesentlich größer ist als das Halbleiterchip selbst, mechanisch äußerst instabil ist, da der Kunststoffzwischenträger mit den Kontakthöckern üblicherweise aus einem flexiblen mit Metall beschichteten Polyamid besteht. Eine Stabilisierung des äußerst labilen äußeren Randes, der über die Halbleiterchipabmessungen hinausragt, ist bisher bei diesem Gehäusetyp nur durch aufwendiges Aufbringen einzelner Gehäuserahmen mit einem zeit- und kostenintensiven Verfahren unter erhöhter Anforderung an die Genauigkeit erreichbar.

Die Aufgabe der vorliegenden Erfindung ist es deshalb, eine Vorrichtung zum Verpacken von elektronischen Bauteilen und ein Verfahren zum Verpacken derartiger Bauteile anzugeben, das die obigen Nachteile beim Vereinzeln von BGA-Gehäusen auf einem Kunststoffzwischenträger überwindet und ein Sägen zuläßt, das keinerlei klebrige Ablagerungen von Sägerückständen entstehen läßt.

Diese Aufgabe wird mit den Merkmalen des Gegenstands der unabhängigen Ansprüche gelöst. Bevorzugte Weiterbildungen der Erfindung ergeben sich aus den abhängigen Ansprüchen.

Gemäß der Erfindung ist zusätzlich zu den Halbleiterchips ein Kunststoffgitter auf dem Kunststoffzwischenträger angeordnet, welches jedes Halbleiterchip rahmenartig umgibt und welches zum Verpacken der Vielzahl von Halbleiterchips mit einer Kunststoffgußmasse zwischen Halbleiterchips und Kunststoffgitter versehen ist. Eine derart ausgestattete Vorrichtung hat den Vorteil, daß beim Sägen nicht mehr die thermoplastische Kunststoffgußmasse mit dem Sägeblatt in Berührung kommt und somit klebrige Rückstände oder Ablagerungen bilden kann, wie z.B. Siliconkugeln, wenn die Vergußmasse aus Silikon besteht, sondern zum Trennen der Vorrichtung zum Verpacken von elektronischen Bauteilen in einzelne elektronische Bauteile kann das Sägeblatt durch das Kunststoffgitter geführt werden, so daß es keinerlei Berührung an den Trennflächen mit der Kunststoffgußmasse hat.

Durch das Anordnen eines Kunststoffgitters in einem herkömmlichen Montagerahmen, so daß teilweise die sonst übliche Kunststoffgußmasse durch das Kunststoffgitter ersetzt wird, kann einerseits ein erheblicher Anteil an Kunststoffgußmasse eingespart werden, und andererseits können die bisherigen Vorrichtungen zum Verpacken von elektronischen Bauteilen ohne Einschränkung weiter verwendet werden.

Darüber hinaus wird mit der erfindungsgemäßen Vorrichtung eine zeit- und kostenintensive Gehäusemontage mit stabilisierenden Einzelrahmen vermieden, denn diese Einzelrahmen entstehen unmittelbar beim Trennen des Kunststoffgitters.

In einer weiteren bevorzugten Ausführungsform der Vorrichtung zum Verpacken von elektronischen Bauteilen wird ein Montagerahmen mit einer einzigen großflächigen Öffnung für eine Vielzahl von Halbleiterchippositionen auf dem Kunststoffzwischenträger ersetzt durch einen erfindungsgemäß verbesserten neuen Montagerahmen, der eine Vielzahl von einzelnen Öffnungen aufweist, die in Form und Größe den zu bildenden elektronischen Bauteilen entsprechen, so daß bei dieser Ausführungsform der Erfindung die Herstellung und Montage eines Kunststoffgitters vor dem Vergießen mit einer Kunststoffgußmasse eingespart wird.

Der Kunststoffzwischenträger mit seiner Vielzahl von Halbleiterchippositionen kann nach wie vor auch für den erfindungsgemäßen verbesserten Montagerahmen eine Verwendung finden. Das hat den Vorteil, daß das Design oder die Konstruktion des Kunststoffzwischenträgers mit den Halbleiterchippositionen und den darauf angeordneten Halbleiterchips und ihren Verbindungen zu den Kontakthöckern über Leiterbahnen des Kunststoffzwischenträgers vollständig beibehalten werden kann. Der Vorteil gegenüber einer Vorrichtung mit einer einzigen großflächigen Öffnung besteht darin, daß beim Vereinzeln der Vielzahl von elektronischen Bauteilen zu einzelnen BGA-Gehäusen die Sägeblätter nicht mehr durch eine Kunststoffgußmasse geführt werden, sondern vollständig in dem Material des Montagerahmens geführt werden. Somit wird auch mit dieser Lösung das Bilden von klebrigen Ablagerungen beim Trennvorgang vermieden.

In einer bevorzugten Ausführungsform ist die Kunststoffmasse eine thermoplastische Siliconmasse. Dieses hat den Vorteil, daß eine flexible, die unterschiedlichen Wärmeausdehnungsverhalten von innerem Halbleiterchip und äußerem Kunststoffgitter durch die thermoplastische Siliconmasse ausgeglichen werden kann, damit keinerlei Spannungen auf den aus dem Kunststoffgitter entstandenen Schutzrahmen oder auf den im Inneren des Schutzrahmens liegenden Halbleiterchip ausgeübt wird.

In einer weiteren bevorzugten Ausführungsform besteht der Montagerahmen aus einem formstabilen Kunststoff. Dies hat den Vorteil, daß der üblicherweise relativ flexible Kunststoffzwischenträger durch Verkleben mit dem Montagerahmen eine relativ stabile Vorrichtung zum Verpacken von elektronischen Bauteilen liefert. Der formstabile Kunststoff kann vorzugsweise aus Polyethylen, Polypropylen, Polyamiden oder Polycarbonaten, Polyvinylchlorid oder Polytetrafluorethylen mit entsprechenden Füllstoffen bestehen.

In einer weiteren bevorzugten Ausführungsform kann der Montagerahmen auch aus einem Duroplast hergestellt werden, wie einem Epoxidharz oder anderen zwei Komponentenkunststoffen. Derartige Kunststoffe haben den Vorteil, daß sie insbesondere beim Sägen keine thermoplastischen und klebrigen Rückstände oder Ablagerungen bilden, sondern spanabhebend bearbeitet werden können.

In einer weiteren bevorzugten Ausführungsform können der Montagerahmen und das Kunststoffgitter aus gleichem Material hergestellt sein, so daß beim Sägen gleiche Rand- und Anfangsbedingungen und gleiche Sägeraten erreicht werden können. In der bevorzugten Ausführungsform der Erfindung, bei dem der Montagerahmen und das Kunststoffgitter ein einstückiges integrales Bauteil mit Öffnungen für jedes Halbleiterchip bilden, wie oben erwähnt, sind der Montagerahmen und das Kunststoffgitter von vornherein aus gleichem Material hergestellt.

Bei einer weiteren bevorzugten Ausführungsform der Erfindung sind die Halbleiterchippositionen auf dem Kunststoffzwischenträger reihen- und spaltenweise angeordnet. Das hat den Vorteil, daß das Trennen in einzelne elektronische Bauteile durch einfaches linear geführtes Sägen der Vorrichtung zum Verpacken von elektronischen Bauteilen möglich wird. Dazu muß lediglich zwischen den Reihen und Spalten der Halbleiterchippositionen jeweils ein Sägeschnitt gelegt werden.

In einer weiteren bevorzugten Ausführungsform der Erfindung ist der Kunststoffzwischenträger bandförmig, was den Vorteil hat, daß einzelne Streifen aus dem Band abgeschnitten und zum Aufbau der Vorrichtung zum Verpacken von elektronischen Bauteilen mit dem formstabilen Montagerahmen verbindbar sind. Die bandförmige Struktur hat darüber hinaus den Vorteil, daß in einer Massenproduktion sowohl das Aufbringen der Halbleiterchips auf dem Zwischenträger als auch das Bilden von Kontakthöckern vorzugsweise aus Kontaktlötbällen kontinuierlich und im Durchlaufverfahren hergestellt werden kann.

Dazu ist der Kunststoffzwischenträger vorzugsweise aus einem flexiblen Polyamid mit zu Leiterbahnen strukturierter Metallbeschichtung hergestellt. Dieses flexible Polyamid hat eine Dicke von bis zu 100 µm, während die Metallbeschichtung für die Leiterbahnen zwischen 0,3 µm und 5 µm liegt.

In einer weiteren bevorzugten Ausführungsform der Erfindung weist das Kunststoffgitter Längs- und Querstege auf, die breiter sind als eine Sägeblattbreite einer Säge zum Trennen der Halbleiterchippositionen zu einzelnen verpackten elektronischen Bauteilen mit Kontakthöckern. Die Breite der Querstege und die Breite der Längsstege müssen jedoch nicht gleich sein, sondern können durchaus unterschiedliche Breiten aufweisen, solange diese Breiten größer sind als die Sägeblattbreite beim Trennen der Halbleiterchippositionen, so daß ein genügend breiter Schutzrand für jedes elektronische Bauelement beim Vereinzeln der Vielzahl von elektronischen Bauelementen entstehen kann.

Vorzugsweise bildet somit das Kunststoffgitter der erfindungsgemäßen Vorrichtung einen Schutzrahmen um jedes der Vielzahl von Halbleiterchips. Selbst, wenn der kunststoffhökkertragende Kunststoffzwischenträger nicht wesentlich größer als der Halbleiterchip ist, wird jedes elektronische Bauteil, das mit der erfindungsgemäßen Vorrichtung verpackt wird, automatisch mit einem Schutzrahmen versehen, was insbesondere dann Bedeutung hat, wenn der kontakthöckertragende Kunststoffzwischenträger wesentlich größer als das Halbleiterchip ist, denn in diesem Fall übernimmt der aus der erfindungsgemäßen Vorrichtung zum Verpacken von elektronischen Bauteilen entstehende Schutzrahmen um jedes der Vielzahl von Halbleiterchips das Stabilisieren des entstehenden Kunststoffgehäuses. Die Genauigkeit und Präzision der elektronischen Bauteile und ihrer Außenabmessungen hängt nicht davon ab, wie genau und präzise ein Einzelrahmen für ein elektronisches Bauteil angeordnet wird, sondern ist nur noch abhängig von der Präzision des Sägetrennschnittes durch das Kunststoffgitter oder den Montagerahmen mit einstückig integriertem Kunststoffgitter.

Das Verfahren zum Verpacken von elektronischen Bauteilen hängt mit seinen Verfahrensschritten davon ab, ob ein erfindungsgemäßes Kunststoffgitter in einem herkömmlichen Montagerahmen angeordnet wird oder ob das erfindungsgemäße Kunststoffgitter mit dem Montagerahmen ein neu konstruiertes einstückiges integrales Bauteil mit Öffnungen für jedes der Halbleiterchips bereitgestellt wird. Dementsprechend wird das erfindungsgemäße Verfahren mit unterschiedlichen Verfahrens-schritten durchführbar sein.

In dem einen Fall wird ein konventioneller Montagerahmen mit einer Öffnung zum Einpassen eines streifenförmigen Kunststoffzwischenträgers bereitgestellt. Der Kunststoffzwischenträger wird dazu mit einer Vielzahl von Kontakthöckerpositionen mit anschließbaren Leiterbahnen, die zu einer Vielzahl von Halbleiterchippositionen führen, bereitgestellt und weist in diesen Positionen Halbleiterchips auf, deren Kontaktflächen mit den Leiterbahnen verbunden sind, während Abstandshalter oder abstandshaltende Schichten aus Kunststoff die Vielzahl von Halbleiterchips auf dem Kunststoffzwischenträger in den Halbleiterchippositionen halten. Sind diese beiden Hauptteile der Vorrichtung zum Verpacken von elektronischen Bauteilen bereitgestellt, wird die Vielzahl von Halbleiterchips in der Öffnung des Montagerahmens unter Aufbringen des Kunststoffzwischenträgers auf dem Montagerahmen positioniert. Danach wird ein erfindungsgemäßes Kunststoffgitter auf dem Kunststoffzwischenträger angeordnet, so daß die Vielzahl der Halbleiterchips von dem Kunststoffgitter rahmenartig umgeben ist. Anschließend wird die Vielzahl von Halbleiterchips durch Vergießen des Zwischenraums mit einer Kunststoffgußmasse zwischen Halbleiterchips und Kunststoffgitter sowie aller Hohlräume zwischen Halbleiterchip und Kunststoffzwischenträger versiegelt. Abschließend wird das Kunststoffgitter in einzelne jedes Halbleiterchip umgebende Schutzrahmen unter Bilden eines verpackten elektronischen Bauteils mit einem formstabilen Schutzrahmen getrennt.

Dieses Verfahren hat den Vorteil, daß unabhängig von den Größenverhältnissen zwischen Halbleiterchip und höckertragendem Kunststoffzwischenträger grundsätzlich ein stabiler Schutzrahmen um jedes der entstehenden und verpackten elektronischen Bauteile gebildet wird. Somit entstehen keine klebrigen Sägerückstände am Gehäuserand, indem ein geeignetes Gittermaterial für ein exaktes Sägen und damit für eine genaue Geometrie ausgewählt wird.

Wird für ein weiteres bevorzugtes Durchführen des Verfahrens zum Verpacken von elektronischen Bauteilen ein Montagerahmen mit einer Vielzahl von Öffnungen zum Einpassen einer Vielzahl von einem Kunststoffzwischenträger an Halbleiterchippositionen getragener Halbleiterchips in den Öffnungen bereitgestellt, so kann der bereitgestellte Kunststoffzwischenträger derart positioniert werden, daß in jeweils einer Öffnung des Montagerahmens ein Halbleiterchip angeordnet ist. Danach erfolgt das Verpacken der Vielzahl von Halbleiterchips durch Vergießen des Zwischenraums mit einer Vergußmasse zwischen Halbleiterchips und Montagerahmen sowie aller Hohlräume zwischen Halbleiterchip und Kunststoffzwischenträger. Nach einem Anbringen der Kontakthöcker in den Kontakthöckerpositionen wird schließlich durch Trennen des Montagerahmens zu einzelnen, jedes Halbleiterchip umgebenden Schutzrahmen ein verpacktes elektronisches Bauteil mit Schutzrahmen gebildet.

Die in dem erfindungsgemäßen Verfahren zu verwendenden Materialien als Gußmasse, Montagerahmen, Kunststoffgitter oder Kunststoffzwischenträger sind die gleichen, wie sie für die erfindungsgemäße Vorrichtung zum Verpacken von elektronischen Bauteilen bereits oben erwähnt werden.

Dazu kann der Montagerahmen aus einem formstabilen Kunststoff mittels eines Spritzgußverfahrens hergestellt werden oder durch Mischen zweier Harzkomponenten zu einem Duroplast in einer geeigneten Form gegossen sein. Beide Verfahren sind auch geeignet, um den Montagerahmen und das Kunststoffgitter einstückig aus gleichem Material herzustellen.

Der Kunststoffzwischenträger aus einem flexiblen Polyamid kann mittels galvanischer Abscheidung mit einer Metallbeschichtung versehen werden, die anschließend zu Leiterbahnen und Kontaktanschlußflächen strukturiert wird.

Die Kontakthöcker können vorzugsweise bei dem erfindungsgemäßen Verfahren und der erfindungsgemäßen Vorrichtung durch Anschmelzen von Lötkontaktkugeln hergestellt sein.

Ausführungsformen der Erfindung werden nun unter Bezugnahme auf die beigefügten Zeichnungen näher erläutert.
Figur 1 zeigt eine Draufsicht einer Vorrichtung zum Verpakken von elektronischen Bauteilen gemäß einer ersten Ausführungsform der Erfindung.
Figur 2 zeigt eine Draufsicht auf einen Montagerahmen mit positioniertem Kunststoffzwischenträger, der eine Vielzahl von Halbleiterchips trägt.
Figur 3 zeigt eine Draufsicht auf ein Kunststoffgitter, das in die erste Ausführungsform der Erfindung gemäß Figur 1 eingesetzt ist.
Figur 4 zeigt eine Draufsicht auf einen Montagerahmen einer zweiten Ausführungsform der Erfindung zum Verpacken von elektronischen Bauteilen.
Figur 5 zeigt eine Draufsicht des Montagerahmens der Figur 4 mit einer Vielzahl positionierter Halbleiterchips in einer Vielzahl von Öffnungen des Montagerahmens.
Figur 6 zeigt einen Ausschnitt der zweiten Ausführungsform der Erfindung nach dem Einbringen der Kunststoffgußmasse entlang der Schnittebene A-A der Figur 5 im Querschnitt.
Figur 7 zeigt einen Querschnitt der zweiten Ausführungsform nach Figur 6 mit Sägeblättern, die beim Trennschritt die elektronischen Bauteile vereinzeln.
Figur 8 zeigt den Querschnitt der zweiten Ausführungsform nach Figur 6 nach dem Trennschritt.

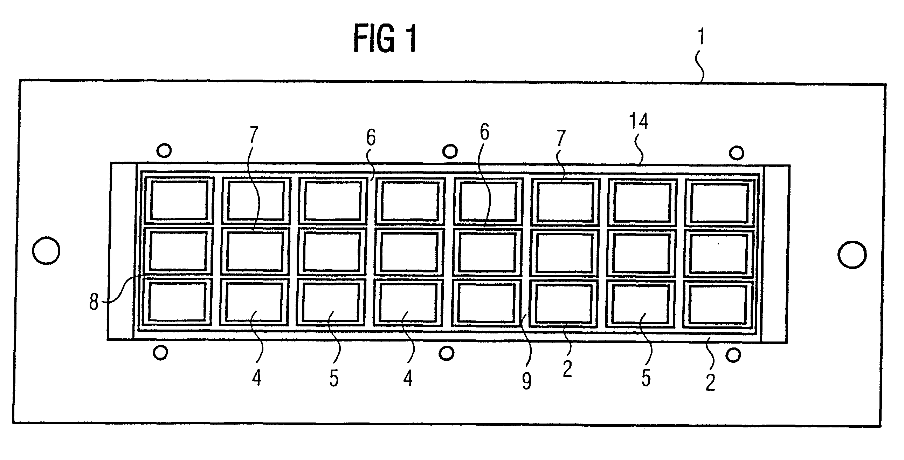

Figur 1 zeigt eine Draufsicht einer Vorrichtung zum Verpacken von elektronischen Bauteilen gemäß einer ersten Ausführungsform der Erfindung. Die Vorrichtung weist in dieser Ausführungsform zum Verpacken von elektronischen Bauteilen einen Montagerahmen 1 auf, der eine einzige große Öffnung 14 umrahmt, die von einem Kunststoffzwischenträger 2 mit einer Vielzahl von Halbleiterchippositionen 4 ausgefüllt wird, welche somit innerhalb des Montagerahmens liegen. Der Kunststoffzwischenträger ist mit seinen in Figur 1 nicht sichtbaren Randzonen mit dem Montagerahmen verbunden.

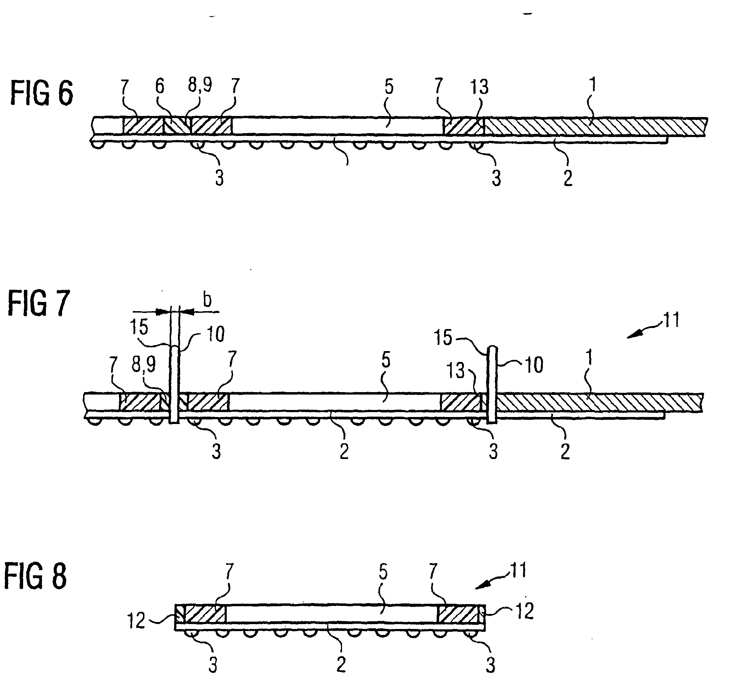

Der Montagerahmen besteht im wesentlichen aus einem formstabilen Kunststoff oder einem Metall, der einen Kunststoffzwischenträger aus flexiblem Kunststoffmaterial präzise halten und positionieren kann. Der Kunststoffzwischenträger weist eine Vielzahl von Kontakthöckern, wie sie in den Figuren 6 bis 8 zu sehen sind, auf, an die Leiterbahnen einer Leiterbahnschicht des Kunststoffzwischenträgers angeschlossen sind. Die Leiterbahnen führen zu der Vielzahl von Halbleiterchippositionen 4 innerhalb des Montagerahmens 1, welche Halbleiterchips 5 aufweisen. Die Kontaktflächen der Halbleiterchips 5 sind mit den Leiterbahnen verbunden und Abstandshalter oder Abstandsschichten aus Kunststoff halten die Halbleiterchips 5 auf dem Kunststoffzwischenträger 2 in den Halbleiterchippositionen 4 fixiert. Zusätzlich ist auf dem Kunststoffzwischenträger 2 ein Kunststoffgitter 6 angeordnet, welches jedes Halbleiterchip 5 rahmenartig umgibt und welches zum Verpacken der Vielzahl von Halbleiterchips 5 mit einer Kunststoffvergußmasse 7 zwischen Halbleiterchips 5 und Kunststoffgitter 6 versehen ist. Die Kunststoffvergußmasse 7 ist in dieser Ausführungsform eine thermoplastische Silikonmasse. Der Montagerahmen 1 ist aus einem formstabilen Kunststoff oder einem Metall hergestellt, so daß der bandförmig aufgebaute Kunststoffzwischenträger 2 in einer stabilen Lage in der Öffnung 14 des Montagerahmens 1 gehalten werden kann.

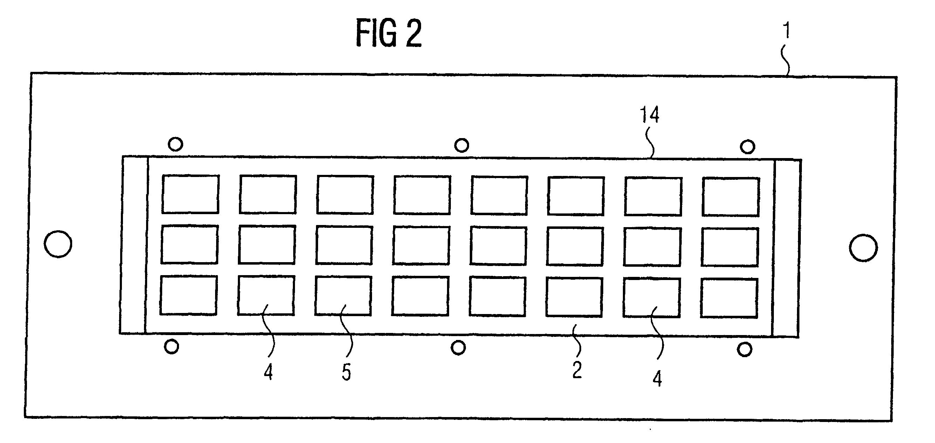

Figur 2 zeigt eine Draufsicht auf einen Montagerahmen 1 mit positioniertem Kunststoffzwischenträger 2, der eine Vielzahl von Halbleiterchips 5 trägt. In diesem Montagezustand der Vorrichtung zum Verpacken von elektronischen Bauteilen ist noch nicht das erfindungsgemäße Kunststoffgitter, das in Fig. 1 zu sehen ist, eingebaut, so daß die reihen- und spaltenweise Anordnung der Halbleiterchippositionen 4 in der Öffnung 14 des Montagerahmens 1 zu erkennen ist.

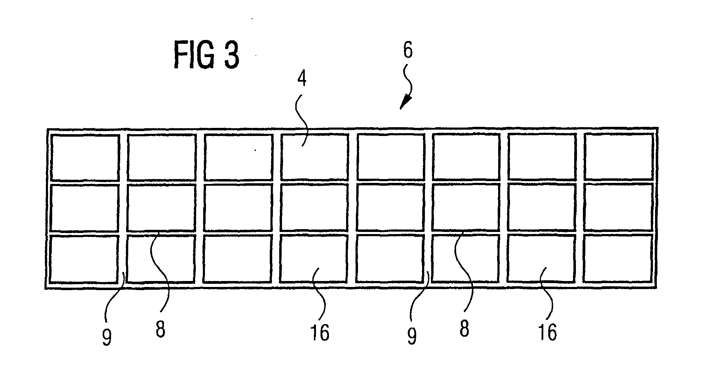

Figur 3 zeigt eine Draufsicht auf ein Kunststoffgitter 6, das in der ersten Ausführungsform der Erfindung gemäß Figur 1 eingesetzt ist, aufgrund der reihen- und spaltenweise Anordnung der Halbleiterchippositionen 4 ist das Kunststoffgitter aus Quer- und Längsstegen 8 und 9 aufgebaut. Die Breite der Stege ist breiter als die Sägeblattbreite b, wie sie in Figur 7 gezeigt wird. Die Quer- und Längsstege 8 und 9 des Kunststoffgitters 6 lassen Öffnungen 16 frei, die in ihren Außen-maßen größer sind als die Halbleiterchipabmessungen der Halbleiterchips 5 an den Halbleiterchippositionen 4. Somit kann das Kunststoffgitter zum Verpacken von elektronischen Bauteilen auf dem Kunststoffzwischenträger 2, der in Fig. 1 und 2 gezeigt wird, positioniert werden. Damit wird durch das Kunststoffgitter 6 ein Teil der Kunststoffgußmasse 7 zum Verpacken von elektronischen Bauteilen ersetzt. Gleichzeitig kann durch das Kunststoffgitter gewährleistet werden, daß die Sägeblätter nicht mehr durch eine thermoplastische Silikonmasse sägen müssen, wie im Stand der Technik, sondern daß die Sägeblätter durch das Material des Kunststoffgitters 6 geführt werden können, so daß keinerlei klebrige oder kugelförmige thermoplastische Ablagerungen durch einen zusätzlichen Säuberungsprozeß mechanisch entfernt werden müssen. Dazu wird ein Kunststoffmaterial für das Kunststoffgitter 6 eingesetzt, das, ohne anzuschmelzen, mit erhöhter Sägegeschwindigkeit spanabhebend bearbeitet werden kann. Mit den Vorteilen der erhöhten Sägegeschwindigkeit aufgrund des Einsatzes des erfindungsgemäßen Kunststoffgitters wird gleichzeitig die Prozeßzeit und damit der Aufwand für das Vereinzeln der Vorrichtung zum Verpacken von elektronischen Bauteilen in einzelne elektronische Bauteile vermindert.

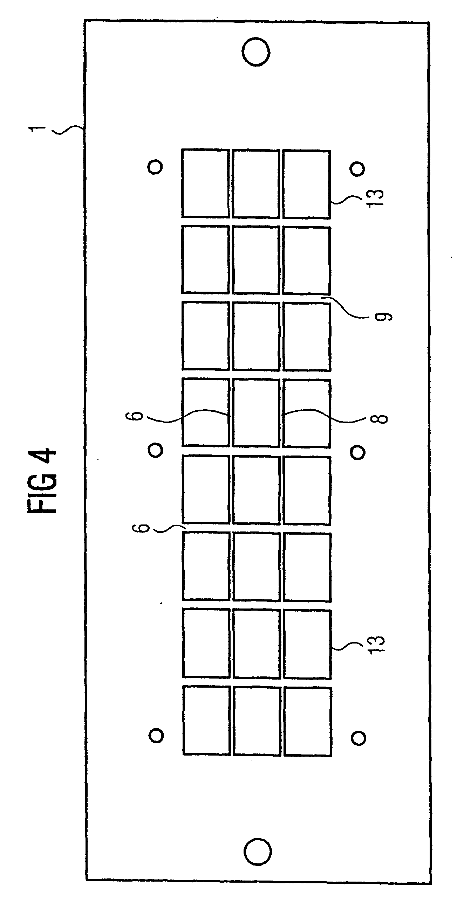

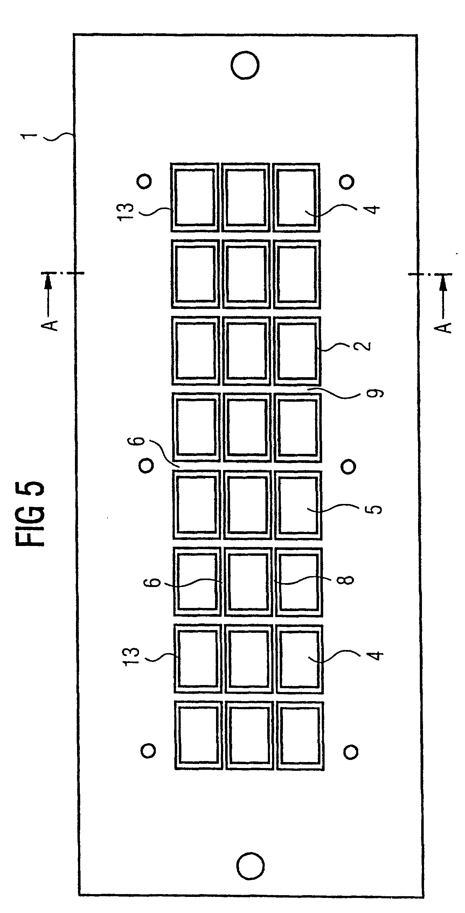

Figur 4 zeigt eine Draufsicht auf einen Montagerahmen 1 einer zweiten Ausführungsform der Erfindung. Wenn für Neukonstruktionen ein verbesserter Montagerahmen 1 zu konstruieren ist, kann dieser ein einstückiges integrales Bauteil mit dem erfindungsgemäßen Kunststoffgitter 6 bilden. Dazu werden in dem Montagerahmen 1 gemäß einer zweiten bevorzugten Ausführungsform der Erfindung, wie ihn Figur 4 zeigt, eine Vielzahl von Öffnungen vorgesehen, die in ihren Abmessungen den Abmessungen der Halbleiterchips 5, wie es Figur 5 zeigt, entsprechen.

Figur 5 zeigt eine Draufsicht des Montagerahmens 1 der Figur 4 mit einer Vielzahl positionierter Halbleiterchips 5 in einer Vielzahl von Öffnungen 13 des Montagerahmens 1. Der Kunststoffzwischenträger 2 ist in Figur 5 im wesentlichen durch den in Figur 4 gezeigten Montagerahmen 1 verdeckt. Lediglich die Halbleiterchips 5 des Kunststoffzwischenträgers sind in ihrer Position innerhalb der Vielzahl der Öffnungen 13 des Montagerahmens 1 zu sehen.

Figur 6 zeigt einen Querschnitt der zweiten Ausführungsform der Erfindung nach dem Einbringen der Kunststoffgußmasse 7 entlang der Schnittebene A-A der Figur 5 im Querschnitt. Der Montagerahmen 1 und das Kunststoffgitter 6 sind in dieser Ausführungsform aus gleichem Material und bilden ein einstükkiges integrales Bauteil, das mit jeder Öffnung 13 ein Halbleiterchip 5 umgibt. Der Kunststoffzwischenträger 2 mit seinen Höckern 3 und den nicht gezeigten Leiterbahnen 4 trägt das Halbleiterchip 5 und der Zwischenraum zwischen Halbleiterchip 5, Montagerahmen 1 bzw. Kunststoffgitter 6 und Kunststoffzwischenträger 2 ist mit Kunststoffgußmasse 7, die in dieser Ausführungsform aus einer Siliconmasse besteht, aufgefüllt.

Figur 7 zeigt den Querschnitt der Ausführungsform nach Figur 6 mit Sägeblättern 15, die beim Trennschritt die elektronischen Bauteile 11 vereinzeln. Die Sägeblattbreite b ist kleiner als die Stegbreite der Stege 8, 9, so daß beim Trennschritt ein Schutzrahmen 12, wie ihn Figur 8 zeigt, entsteht.

Figur 8 zeigt den Querschnitt der Ausführungsform nach Figur 6 nach dem Trennschritt. Nach diesem Schritt entstehen vereinzelte elektronische Bauelemente 11 mit einem durch einen Kunststoffrahmen 12 verstärkten Gehäuse, aus dem die Kontakthöcker 3 herausragen, und das den Halbleiterchip 5 in seinem Randbereich vollständig mit Kunststoffgußmasse 7 umgibt. Durch das Vergießen der Vorrichtung zum Verpacken von elektronischen Bauteilen mit einer Kunststoffgußmasse im Vakuum wird gleichzeitig sichergestellt, daß alle Hohlräume zwischen Halbleiterchip 5 und Kunststoffzwischenträger 2 mit der Kunststoffgußmasse 5 ausgefüllt werden, so daß ein formstabiles elektronisches Bauteil gefertigt werden kann.

## Patentansprüche

1. Vorrichtung zum Verpacken von elektronischen Bauteilen mit Montagerahmen (1), der einen Kunststoffzwischenträger (2) umrahmt und hält, wobei der Kunststoffzwischenträger (2) an eine Vielzahl von Kontakthöckern (3) angeschließbare Leiterbahnen aufweist, die zu einer Vielzahl von Halbleiterchippositionen (4) innerhalb des Montagerahmens (1) führen und in diesen Positionen Halbleiterchips (5) aufweisen, deren Kontaktflächen mit den Leiterbahnen verbunden sind, während Abstandhalter aus Kunststoff die Halbleiterchips (5) auf dem Kunststoffzwischenträger (2) in den Halbleiterchippositionen (4) halten, wobei zusätzlich zu den Halbleiterchips (5) ein Kunststoffgitter (6) auf dem Kunststoffzwischenträger (2) angeordnet ist, welches jedes Halbleiterchip (5) rahmenartig umgibt und welches zum Verpacken der Vielzahl von Halbleiterchips mit einer Kunststoffgußmasse (7) zwischen Halbleiterchips (5) und Kunststoffgitter (6) versehen ist.

2. Vorrichtung nach Anspruch 1,
**dadurch gekennzeichnet, daß**
die Kunststoffgußmasse (7) eine thermoplastische Siliconmasse ist.

3. Vorrichtung nach Anspruch 1 oder Anspruch 2,
**dadurch gekennzeichnet, daß**
der Montagerahmen (1) aus einem formstabilen Kunststoff oder einem Metall hergestellt ist.

4. Vorrichtung nach Anspruch 1 oder Anspruch 2,
**dadurch gekennzeichnet, daß**
der Montagerahmen (1) aus einem Duroplast hergestellt ist.

5. Vorrichtung nach einem der vorhergehenden Ansprüche,
**dadurch gekennzeichnet, daß**
der Montagerahmen (1) und das Kunststoffgitter (6) aus dem gleichen Material hergestellt sind.

6. Vorrichtung nach einem der vorhergehenden Ansprüche,
**dadurch gekennzeichnet, daß**
die Halbleiterchippositionen (4) auf dem Kunststoffzwischenträger (2) reihen- und spaltenweise angeordnet sind.

7. Vorrichtung nach einem der vorhergehenden Ansprüche,
**dadurch gekennzeichnet, daß**
der Kunststoffzwischenträger (2) bandförmig ist.

8. Vorrichtung nach einem der vorhergehenden Ansprüche,
**dadurch gekennzeichnet, daß**
der Kunststoffzwischenträger (2) aus einem flexiblen Polyamid mit zu Leiterbahnen strukturierter Metallbeschichtung hergestellt ist.

9. Vorrichtung nach einem der vorhergehenden Ansprüche,
**dadurch gekennzeichnet, daß**
das Kunststoffgitter (6) Längs-(8) und Querstege (9) aufweist, die breiter sind als eine Sägeblattbreite (b) einer Säge (10) zum Trennen der Halbleiterchippositionen (4) zu einzelnen verpackten elektronischen Bauteilen (11) mit Kontakthöckern (3).

10. Vorrichtung nach einem der vorhergehenden Ansprüche,
**dadurch gekennzeichnet, daß**
das Kunststoffgitter (6) einen Schutzrahmen (12) um jedes einzelne der Vielzahl von Halbleiterchips (5) bildet.

11. Vorrichtung nach einem der vorhergehenden Ansprüche,
**dadurch gekennzeichnet, daß**
der Montagerahmen (1) und das Kunststoffgitter (6) ein einstückiges integrales Bauteil sind mit Öffnungen (13) für jedes Halbleiterchip (5).

12. Vorrichtung nach einem der vorhergehenden Ansprüche,
**dadurch gekennzeichnet, daß**
der Montagerahmen (1), der die Öffnungen (13) für die Halbleiterchips (5) umgibt, breiter ist als eine Sägeblattbreite (b) einer Säge (10) zum Trennen der Halbleiterchippositionen (4) zu einzelnen verpackten elektronischen Bauteilen (11) mit Kontakthöckern (3).

13. Verfahren zum Verpacken von elektronischen Bauteilen (11) gemäß einem der Ansprüche 1 bis 12 mit folgenden Verfahrensschritten:
- Bereitstellen eines Montagerahmens (1) mit einer Öffnung (14) zum Einpassen eines streifenförmigen Kunststoffzwischenträgers (2),
- Bereitstellen eines Kunststoffzwischenträgers (2) für eine Vielzahl von Kontakthöckern (3) mit anschließbaren Leiterbahnen, die zu einer Vielzahl von Halbleiterchippositionen (4) führen und in diesen Positionen Halbleiterchips (5) aufweisen, deren Kontaktflächen mit den Leiterbahnen verbunden sind, während Abstandhalter aus Kunststoff die Vielzahl der Halbleiterchips (5) auf dem Kunststoffzwischenträger (1) in den Halbleiterchippositionen (4) halten,
- Positionieren der Vielzahl von Halbleiterchips (5) in der Öffnung (14) des Montagerahmens (1) unter Aufbringen des Kunststoffzwischenträgers (2) auf dem Montagerahmen (1),
- Positionieren eines Kunststoffgitters (6) auf dem Kunststoffzwischenträger (2), so daß die Vielzahl der Halbleiterchips (5) von dem Kunststoffgitter (6) rahmenartig umgeben wird,
- Versiegeln der Vielzahl von Halbleiterchips (5) durch Vergießen des Zwischenraums zwischen Halbleiterchips (5) und Kunststoffgitter (6) mit einer Kunststoffgußmasse (15), sowie aller Hohlräume zwischen Halbleiterchip (5) und Kunststoffzwischenträger (2) und
- Trennen des Kunststoffgitters (6) zu einzelnen jedes Halbleiterchip (5) umgebenden Schutzrahmen (12) unter Bilden eines verpackten elektronischen Bauteils (11) mit formstabilen Schutzrahmen (12).

14. Verfahren zum Verpacken von elektronischen Bauteilen gemäß einem der Ansprüche 1 bis 12, **gekennzeichnet durch** folgende Verfahrensschritte:
- Bereitstellen eines Montagerahmens (1) mit einer Vielzahl von Öffnungen (13) zum Einpassen einer Vielzahl auf einem Kunststoffzwischenträger (2) an Halbleiterchippositionen (4) getragener Halbleiterchips (5) in die Öffnungen (13),
- Bereitstellen eines Kunststoffzwischenträgers (2) mit einer Vielzahl von Kontakthöckern (3) mit angeschlossenen Leiterbahnen, die zu einer Vielzahl von Halbleiterchippositionen (4) führen und in diesen Positionen Halbleiterchips (5) aufweisen, deren Kontaktflächen mit den Leiterbahnen verbunden sind, während Abstandhalter aus Kunststoff die Vielzahl der Halbleiterchips (5) auf dem Kunststoffzwischenträger (2) in den Halbleiterchippositionen (4) halten,
- Positionieren der Vielzahl von Halbleiterchips (5) in den Öffnungen (13) des Montagerahmens (1) unter Aufbringen des Kunststoffzwischenträgers (1) auf dem Montagerahmen (1), so daß jedes der Halbleiterchips (5) von dem Montagerahmen (1) umgeben wird,
- Verpacken der Vielzahl von Halbleiterchips (5) **durch** Vergießen des Zwischenraums mit einer Kunststoffgußmasse (7) zwischen Halbleiterchips (5) und Montagerahmen (1), sowie aller Hohlräume zwischen Halbleiterchip (1) und Kunststoffzwischenträger (2), und
- Trennen des Montagerahmens (1) zu einzelnen jedes Halbleiterchip (5) umgebenden Schutzrahmen (12) unter Bilden eines verpackten elektronischen Bauteils (11) mit Schutzrahmen (12).

15. Verfahren nach Anspruch 13 oder 14,
**dadurch gekennzeichnet, daß**
als Kunststoffgußmasse (15) eine thermoplastische Siliconmasse eingesetzt wird.

16. Verfahren nach einem der Ansprüche 13 bis 15,
**dadurch gekennzeichnet, daß**
der Montagerahmen (1) aus einem formstabilen Kunststoff mittels eines Spriztgußverfahrens hergestellt wird.

17. Verfahren nach einem der Ansprüche 13 bis 16,
**dadurch gekennzeichnet, daß**
der Montagerahmen (1) aus einem Duroplast durch Mischen zweier Harzkomponenten hergestellt wird.

18. Verfahren nach einem der Ansprüche 13 bis 17,
**dadurch gekennzeichnet, daß**
der Montagerahmen (1) und das Kunststoffgitter (6) aus dem gleichen Material in einem Spritzgußverfahren hergestellt werden.

19. Verfahren nach einem der Ansprüche 13 bis 18,
**dadurch gekennzeichnet, daß**
der Kunststoffzwischenträger (2) aus einem flexiblen Polyamid mit zu Leiterbahnen strukturierter Metallbeschichtung, die mittels galvanischer Abscheidung und anschließender Strukturierung hergestellt wird.

20. Verfahren nach einem der Ansprüche 13 bis 19,
**dadurch gekennzeichnet, daß**
die Kontakthöcker (3) durch Anschmelzen von Lötkontaktkugeln hergestellt werden.
